Europäisches Patentamt

(19) European Patent Office  (11) Publication number: **0 182 920**

Office européen des brevets  **A1**

(12) **EUROPEAN PATENT APPLICATION**

published in accordance with Art. 158(3) EPC

(21) Application number: **85902653.6**  (51) Int. Cl.⁴: **G 02 B 6/42**
                                              **H 01 L 31/00, H 01 L 31/12**
(22) Date of filing: **29.05.85**               **H 01 L 33/00, H 05 K 1/18**

Data of the international application taken as a basis:

(86) International application number:
**PCT/JP85/00296**

(87) International publication number:
**WO85/05698 (19.12.85 85/27)**

(30) Priority: **30.05.84 JP 108379/84**

(43) Date of publication of application:
**04.06.86 Bulletin 86/23**

(84) Designated Contracting States:
**DE FR GB**

(71) Applicant: **HITACHI, LTD.**
6, Kanda Surugadai 4-chome Chiyoda-ku
Tokyo 100(JP)

(72) Inventor: **NORO, Takanobu** 656, Katakura-cho
Kanagawa-ku
Yokohama-shi Kanagawa 221(JP)

(72) Inventor: **ONODA, Seiichi**
3-19-4, Nakaarai Tokorozawa-shi
Saitama 359(JP)

(72) Inventor: **KOAKUTSU, Yasumasa**
3-12-18, Sakuragaoka Kugenuma
Fujisawa-shi Kanagawa 251(JP)

(72) Inventor: **ARIMA, Hideo**
2418-8, Totsuka-cho Totsuka-ku
Yokohama-shi Kanagawa 244(JP)

(72) Inventor: **YOKONO, Hitoshi**
3-21-6, Mirokuji Fujisawa-shi
Kanagawa 251(JP)

(72) Inventor: **TANAKA, Minoru**
33-12, Hirato 2-chome Totsuka-ku
Yokohama-shi Kanagawa 244(JP)

(72) Inventor: **TODA, Gyozo**
1-23-3, Higashitoyoda Hino-shi
Tokyo 191(JP)

(74) Representative: **Altenburg, Udo, Dipl.-Phys. et al,**
Patent- und Rechtsanwälte
Bardehle-Pagenberg-Dost-Altenburg-Frohwitter &
Partner Postfach 86 06 20
D-8000 München 86(DE)

(54) **SUBSTRATE MOUNTING OPTICAL TRANSMISSION MODULE.**

(57) A substrate (1) on which is mounted an optical transmission module which receives and transmits optical signals. A wave directing portion (2) of light such as face plate is buried in a portion of the substrate (1), electric wirings (3), (5) are provided on at least one surface thereof, photo-electric converter elements such as light-receiving element (8), light-emitting element (9) and the like are mounted on electric element-mounting portions (4a), (4b) on the substrate (1) where the wave directing portion (2) of light is provided, and said photo-electric converter elements are connected to said electric wiring (3), (5), in order to facilitate the coupling between said photo-electric converter elements and the optical fiber (6). This makes it possible to reduce the size of equipment, to simplify assembly, to increase production, and to decrease the manufacturing costs.

*FIG. 4*

EP 0 182 920 A1

## DESCRIPTION

OPTICAL TRANSMISSION MODULE ASSEMBLY SUBSTRATE

Technical Field:

This invention relates generally to an optical transmission module assembly, and more particularly to an optical transmission module assembly which connects a photo detector, a light emitting element and an optical transmission fiber with a high level of optical coupling efficiency, and which is suitable for mounting these members and electrical elements which are necessary for the transmission and reception of signals efficiently, compactly and at high density.

Background Art:

Optical communications have made a remarkable progress in recent years, and applications of the optical communications to communication trunk lines, electric power plants, office automation (OA), factory automation (FA), local area networks (LAN), and further to subscriber transmission systems in information network system (INS) programs have been examined. It is of importance for the application of optical communications to these communication fields to establish those techniques which can reduce the cost of production of appliances and components necessary for constituting the system and the size of modules, can simplify the assembly procedures and can produce them on a mass-basis.

Coupling portions of a light emitting element and an optical fiber in such transmission modules have been assembled by use of discrete spherical lenses or rod lenses, as disclosed in Japanese Patent Laid-Open No. 117114/1968, for example. In accordance with this method, however, much time and labor are necessary for the alignment of axes between the lens and the fiber and their setting. Since the tolerance for the light emitting element, the lens and the fiber is very fine in this method, assembly has been extremely difficult. Furthermore, a predetermined gap which matches the focal distance of the lens must be secured. For this reason, the length in the direction of the optical axis involves a predetermined limit and cannot be reduced very much. In addition, a separate space must be secured to mount electrical elements for driving the light emitting element and for encoding signals. A reception system must also be added for bidirectional communication. For the reasons described above, the assembly procedures have been diversified and complicated and mass-producibility has been low so that the size and cost of production of the system can not be reduced easily.

Disclosure of Invention:

It is an object of the present invention to provide an optical transmission module assembly substrate which can easily couple a photo detector and/or a light emitting element with an optical fiber, can reduce the size and cost of an optical transmission module and electro-optical appliances, can improve producibility, can simplify the assembly and can reduce the cost of production of a system as a whole.

The present invention is characterized in that a waveguide portion for light is embedded into a part of a substrate, an electric wiring portion is formed on at least one surface of the substrate, and photo-electric conversion elements are connected to the electric wiring portion in the vicinity of the optical waveguide portion.

According to this construction, an optical fiber and the photoelectric conversion elements (photo detector/light emitting element) can be easily coupled with one another via the optical waveguide portion, and the optical coupling efficiency is extremely high. Since the optical components and the electrical components are mounted on the single substrate, the size of the module can be reduced, its producibility can be improved, the assembly can be simplified and the cost of production can be reduced.

Brief Description of Drawings:

Fig. 1 is a plan view of an optical transmission module assembly substrate in its production process in accordance with the present invention;

Fig. 2 is an exploded perspective view of the principal portions of the module shown in Fig. 1;

Fig. 3 is a perspective view of a completed module when the present invention is applied to a bidirectional optical communication module; and

Fig. 4 is a sectional view of Fig. 3.

Best Mode For Carrying Out the Invention:

Hereinafter, an embodiment of the present invention will be described in detail with reference to the accompanying drawings.

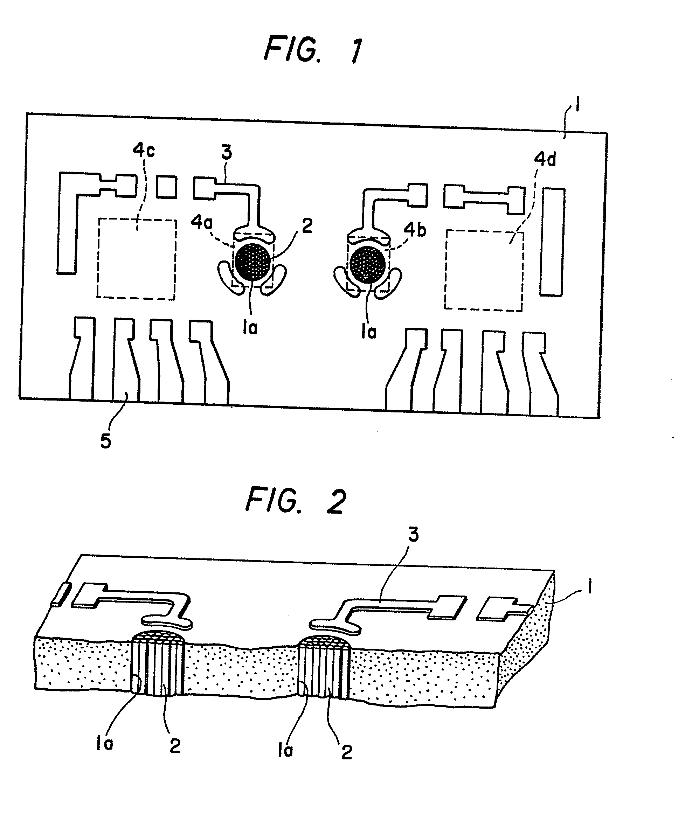

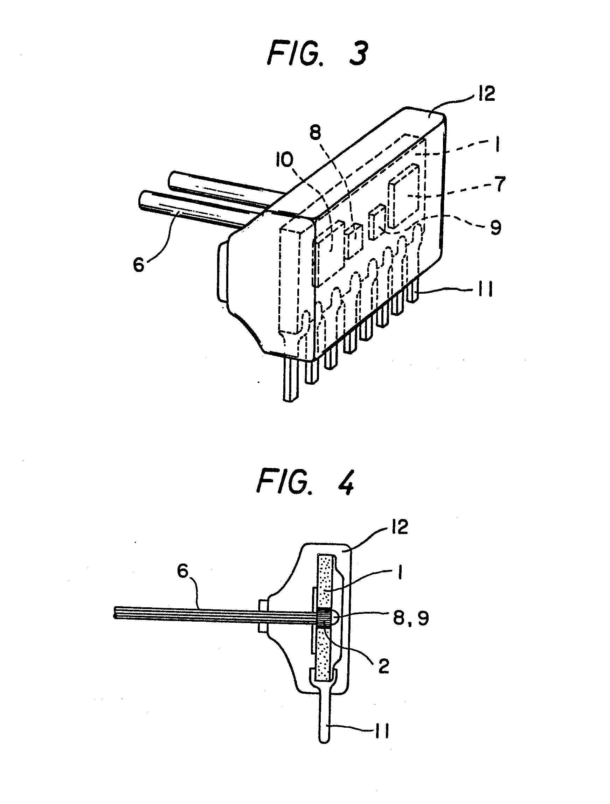

Figs. 1 and 2 show the production process in accordance with the present invention. In the drawings, reference numeral 1 represents a substrate made of ceramic or an organic material, for example, and two holes 1a are bored in the substrate 1. A face plate 2 as a waveguide portion for an optical signal from or to an optical fiber is fused to each hole 1a by a fusing material. Reference numerals 4a through 4d represent portions to which electric elements are to be mounted. A photo detector 8, a light emitting element 9, an IC 10 for the photo detector and an IC 7 for the light emitting element are mounted to these mounting portions 4a, 4b, 4c and 4d, respectively, as depicted in Fig. 3. Reference numerals 3 and 5 represent an electric wiring portion to be electrically connected to these elements 7 through 10 and a wiring portion for bonding a terminal pin, respectively. Though not shown particularly in the drawing, the wiring portion 5 includes a power terminal portion and a ground terminal portion, and a data-out terminal and a data-in terminal are disposed on the side of the photo detector and on the side of the light emitting element, respectively.

Figs. 3 and 4 are a perspective view of a completed module and its sectional view, respectively. Tme elements 7 through 10 are mounted to one of the surfaces of the substrate shown in Figs. 1 and 2, and an optical transmission fiber 6 is extended on the other surface in such a manner as to continue the optical axis of the face plate 2. Reference numeral 11 represents a terminal pin, which is coupled electrically and mechanically to the wiring portion 5. Reference numeral 12 represents a cover mold, which protects the elements 7 through 10, the terminal pin 11 and the optical transmission fiber 6 and also holds mechanically the optical transmission fiber 6.

In practice, the terminal pin 11 of the module completed in this manner may be fitted, for example, into a through-hole of a printed circuit board (not shown). This module exhibits the following optical and electrical action. An optical signal transmitted through the optical transmission fiber 6 is received by the photo detector 8 through the faceplate 2, and is electrically processed by the IC 10 for the photo detector and by a reception circuit on the printed circuit board. An electric signal for transmission is generated by a transmission circuit on the printed circuit board and by the IC 7 for the light emitting element, is then converted to an optical signal by the light emitting element 9, and is thereafter transmitted into another optical transmission fiber 6 through the faceplate 2.

As described above, two faceplates 2 are embedded into the substrate, the photo detector 8 is fitted to one of the faceplates in such a manner as to continue the optical axis of the former faceplate while the light emitting element 9 is fitted to the other faceplate in such a manner as to continue the optical axis of the other faceplate, thereby providing the bidirectional optical communication module.

Next, element components and element technique in the present invention will be explained.

[Optical guidewave portion and material (see Table 1)]

The faceplate, the optical fiber and a rod lens can be mentioned as the materials of the optical waveguide portion which is one of the important elements of the substrate of the present invention.

The faceplate is produced by bundling a plurality of glass fibers each having a core diameter of up to about 15 μm and fusing them with a low melting glass. The bundle of the fused glass fibers is then cut in round slices and the cut surface is polished to provide a so-called "faceplate". When the resulting faceplates are embedded into the substrate 1, the photo detector and the light emitting element can be coupled with the optical transmission fiber directly through the substrate 1 for mounting the electrical components, without using discretely the spherical lens or the rod lens that has been necessary in the prior art module. An optical fiber or a rod lens can be used as another waveguide material.

The linear thermal expansion coefficients (hereinafter referred simply to as "thermal expansion coefficients") of these faceplates, optical fiber and rod lens differ depending upon their material composition. The coefficients generally range from 80 to $100 \times 10^{-7}/°C$ for the faceplate, and from 35 to $80 \times 10^{-7}/°C$ for the optical fiber and the rod lens (multi-component glass).

[Substrate and fusing material (see Tables 2 and 3)]

The following is one of the important conditions for the substrate. This has been made clear as a result of a series of experiments that led to the development of the present invention.

(1) The difference of the thermal expansion coefficients between the substrate material, the material of the optical waveguide and the fusing material for bonding and fixing them must be within $15 \times 10^{-7}/°C$.

This is to prevent the occurrence of cracks on the substrate due to heating and cooling in the embedding process of the waveguide portion of the substrate and due to the thermal shock resulting from the exothermic effect of the electric and optical circuit elements during the practical operation of the module. Table 5 illustrates the result of experiments conducted using materials having different thermal expansion coefficients between the substrate material, the waveguide material and the fusing material. As can be seen clearly from this table, cracks did not develop when the differences of the thermal expansion coefficients of the materials used were within $15 \times 10^{-7}/°C$. Therefore, the substrate material having a thermal expansion coefficient close to that of the waveguide material to be used must be first selected.

For example, the thermal expansion coefficient of a ceramic substrate changes in the following manner depending upon its composition and production method.

Table 1  Waveguide material

| No. | kind | thermal expansion coefficient $(x10^{-7}/°C)$ | dimension (mm) | aperture ratio | core diameter (μm) |
|---|---|---|---|---|---|
| 1 | faceplate | 94 | 3.5φx1.0t | NA=0.55 | 15 |
| 2 | " | 85 | " | NA=0.66 | 7 |
| 3 | " | 83 | " | NA=1.0 | 5 |
| 4 | rod lens | 60 | 2.0φx1.0ℓ | NA=0.55 | 1000 |
| 5 | fiber | 40 | 0.25φx1.0ℓ | NA=0.55 | 200 |

Table 2    Substrate material

| No. | kind | thermal expansion coefficient $(\times 10^{-7}/°C)$ | dimension (mm) | through-hole* (mm) | strength $(kg/mm^2)$ |
|---|---|---|---|---|---|
| 1 | alumina type | 80 | 20 x 7 x 1.0 | 4.0⌀, 2 pcs | 30 |
| 2 | " | 70 | " | " " | " |
| 3 | " | 65 | " | " " | " |
| 4 | mullite type | 55 | " | 2.5⌀, 2 pcs | 23 |
| 5 | glass ceramic type | 40 | " | 0.28⌀, 2 pcs | 18 |

* through-hole for embedding the waveguide material

Table 3  fusing material

| No. | kind | thermal expansion coefficient $(\times 10^{-7}/°C)$ | working temperature (°C) | composition ratio·additives (wt.%) |
|---|---|---|---|---|
| 1 | $PbO-ZnO-B_2O_3$ type | 95 | 465 | $PbO-ZnO-B_2O_3-SiO_2-Al_2O_3-BaO$ (74.0-10.0-9.0-3.0-1.0-3.0) |
| 2 | $PbO-B_2O_3-ZnO$ type | 82 | 500 | $PbO-B_2O_3-ZnO-V_2O_5-others$ (73.2-19.0-4.4-3.3-0.1) |
| 3 | " | 73 | 490 | $PbO-B_2O_3-ZnO-others$ (71.6-21.3-6.9-0.2) |

| No. | kind | thermal expansion coefficient $(\times 10^{-7}/°C)$ | working temperature $(°C)$ | composition ratio·additives (wt.%) |
|---|---|---|---|---|
| 4 | $PbO$-$B_2O_3$-$ZnO$ type | 66 | 460 | $PbO$-$B_2O_3$-$ZnO$-others (75.6-18.8-5.5-0.1) |
| 5 | " | 52 | 495 | $PbO$-$B_2O_3$-$ZnO$-others (68.6-21.4-9.9-0.1) |
| 6 | $SiO_2$-$B_2O_3$-$Al_2O_3$ type | 40 | 685 | $SiO_2$-$B_2O_3$-$Al_2O_3$-$MgO$-others (40.0-40.0-10.0-5.0-5.0) |

Table 4    Embodiments

| No. | waveguide material | | substrate material | | fusing material | | wiring material |
|---|---|---|---|---|---|---|---|
| | kind | $\alpha$* | kind | $\alpha$* | composition (type) | $\alpha$* | |
| 1 | faceplate (Table 1, No. 1) | 94 | alumina type (Table 2, No. 1) | 80 | Table 3, No. 1 | 95 | Ag-Pd,Au |
| 2 | faceplate (Table 1, No. 3) | 83 | alumina type ( - do - ) | 80 | Table 3, No. 2 | 82 | Ag-Pd,Au |
| 3 | Rod lens (Table 1, No. 4) | 60 | mullite type (Table 2, No. 4) | 55 | Table 3, No. 5 | 52 | W-Mo,Au |
| 4 | fiber (Table 1, No. 5) | 40 | glass ceramics (Table 2, No. 5) | 40 | Table 3, No. 6 | 40 | Cr-Cu-Au |

* thermal expansion coefficient $(\times 10^{-7}/°C)$

Table 5   Embodiments with varied
thermal expansion coefficients

| No. | waveguide material (α)* | substrate material (α)* | fusing material (α)* | maximum α difference* | existence of cracks | evaluation |
|---|---|---|---|---|---|---|
| 1 | Table 1, No. 1 (94) | Table 2, No. 1 (80) | Table 3, No. 1 (95) | 15 | nil | o |
| 2 | " (94) | " (80) | Table 3, No. 3 (73) | 21 | extremely small | Δ |
| 3 | Table 1, No. 2 (83) | Table 2, No. 2 (70) | Table 3, No. 1 (95) | 25 | a few | x |
| 4 | Table 1, No. 1 (94) | Table 2, No. 1 (80) | Table 3, No. 4 (66) | 28 | many | x |
| 5 | " (94) | Table 2, No. 3 (65) | Table 3, No. 1 (95) | 30 | " | x |

* thermal expansion coefficient $(\times 10^{-7}/°C)$

forsterite type of substrate    ...   $80 \sim 98 \times 10^{-7}/°C$

alumina type of substrate       ...   $65 \sim 80 \times 10^{-7}/°C$

mullite type of substrate       ...   $40 \sim 50 \times 10^{-7}/°C$

glass ceramic type of substrate...   $30 \sim 100 \times 10^{-7}/°C$

Therefore, the thermal expansion coefficients of the substrate which matches the thermal expansion coefficients of various waveguide portion to be embedded can be selected within the range 30 to 100 $x \ 10^{-7}/°C$.

The fusing material between the two members described above in the present invention must satisfy the following requirements.

(2)    The fusing temperature must be below 700°C. This is to prevent deterioration of the characteristics of the waveguide material due to the heat-treatment for fusing the substrate and the waveguide member.

(3)    The difference of the thermal expansion coefficients, after fusing of the fusing material, between the substrate and the waveguide material must be within $15 \times 10^{-7}/°C$. As the fusing materials for the substrate satisfying this requirement, any of the following materials will serve:

1.    $PbO-ZnO$ (or $SiO_2$) - $B_2O_3$ type of glass frit

2.    $ZnO-B_2O_3-SiO_2$ (or $V_2O_5$) type of glass frit

3.    $SiO_2-B_2O_3-Al_2O_3-MgO$ (or $BaO$) type of glass frit

The fusing temperature and thermal expansion coefficient of each of these materials can be shifted to the range 350 to 685°C and to the range of from 40 to $120 \times 10^{-7}/°C$, respectively, by changing their composition ratio.    Therefore, they can be used for fusing waveguide and substrate materials having various thermal expansion coefficients.

[Substrate wiring method]

Next, the electric wiring method will be explained.

A thick film method and a thin film method can be primarily employed as the electric wiring method. In the thick film method, an Ag-Pd type paste and other conductive pastes are effective. In the thin film method, a wiring method using a Cr-Ni (or Cu) - Au conductor is effective. This wiring step can be carried out either before or after the embedding step of the waveguide portion.

In the manner described above, the assembly substrate on which the electric and optical circuit elements are mounted and to which the optical fibers necessary for optical transmission are connected can be obtained by use of the materials and structures in accordance with the present invention. If a ceramic is used as the substrate, (1) bending strength, (2) sealability and (3) electric wiring property can be obtained. These characteristics are important practically for the substrate. The strength of item (1) must be at least 15 kg/mm$^2$, and is necessary when packaging the substrate or when connecting the terminal pin. The sealability (2) is necessary when hermetically sealing the package. The electric wiring property (3) is effective in order to secure mass-producibility of the substrate, the reduction of its cost of production, a longer service life and higher reliability.

Some definite examples of the production method of the substrate in accordance with the present invention to obtain the various characteristics described above will now be given.

[Example 1 (Table 4, No. 1)]

The electric wiring portion shown in Fig. 1 was printed on an alumina substrate of Table 2, No. 1 using Ag-Pd and Au pastes, respectively. The Au paste was used for the wiring portion 3 for wire-bonding the electric elements while the Ag-Pd paste was used for the wiring portion 5 for bonding the electric terminal.

Next, the substrate after printing was baked at 850°C for 10 minutes inside a belt furnace to form an electric wiring portions by a thick film.

A heat-resistant polyimide resin was coated on the mirror polished end surface of the faceplate shown in Table 1, No. 1, and the faceplate was fitted into the hole 1a of the substrate described above. In this case, each faceplate 2 was set horizontally to the substrate 1.

Next, a solid body (0.5 mm square) of a PbO-ZnO-$B_2O_3$ type low melting glass frit shown in Table 3, No. 1 was placed around each faceplate and was heated at 465°C for 15 minutes.  In this instance, the glass frit was fused and came into the gap between the hole 1a of the substrate 1 and the faceplate 2.  The rate of temperature rise for this fusing heat-treatment was 50°C/hr.

Next, the polyimide resin coated on the end surface of the optical waveguide portion of the faceplate 2 fitted to the substrate 1, which was cooled to room temperature, was removed, and the substrate was washed with an organic solvent and water in a ultrasonic washing device to obtain a clean substrate.

The substrate of the invention obtained in this manner could be used for the assembly substrate of an optical transmission module for optical communications using optical fibers, for example, as will be shown elsewhere.

[Example 2 (Table 4, No. 2)]

After the electric wiring portion was formed on the alumina type substrate shown in Table 2, No. 1 in the same way as in Example 1, the faceplate 2 shown in Table 1, No. 3 was embedded into the sub-

strate using a PbO-$B_2O_3$-ZnO type low melting glass frit shown in Table 3, No. 2. This fusing heat-treatment for embedding the waveguide portion was carried out at 500°C for 20 minutes at a rate of temperature rise of 50°C/hr.

[Example 3 (Table 4, No. 3)]

The electric wiring portion shown in Fig. 1 was printed on a mullite green sheet shown in Table 2, No. 4 using a W-Mo type paste, and was baked at 1,550°C for one hour (in $N_2$ + $H_2$ + $H_2O$) to obtain a substrate equipped with the wiring. Next, about 3 µm thick Au was deposited on the surface of the wiring by plating.

After the substrate described above was sufficiently washed with water, a rod lens shown in Table 1, No. 4 was embedded in the same way as in Example 1. A PbO-$B_2O_3$-ZnO type glass frit shown in Table 3, No. 5 was used for fusing this rod lens, and the heat-treatment conditions was 495°C for 25 minutes and a rate of temperature rise of 50°C/hr.

[Example 4 (Table 4, No. 4)]

An organic binder consisting of polyvinyl butyral and its solvent (n-butyl alcohol) was added to the starting powder of a green sheet consisting of 45 wt% of an $SiO_2$-$B_2O_3$-$Al_2O_3$-MgO low melting glass frit, and 55 wt% quartz glass powder, and was mixed by a ball mill for eight hours. Next, a 1.2 mm thick glass ceramic type green sheet was prepared from the mixed slip using a casting machine. The green sheet was cut in such a fashion that its finished size after baking was such as shown in Table 2, No. 5, and the hole 1a was bored by punching.

Next, a fiber shown in Table 1, No. 5 was inserted into this finished green sheet and was then baked at 685°C for one hour. A rate of temperature rise in this case was 50°C/hr. Baking of this green sheet made it possible to simultaneously fuse the fiber as the waveguide material.

Next, the substrate described above was polished for about 3 minutes by a 1/4 $\mu$m diamond paste in order to remove any deposited matter on the end surface of the waveguide portion of the baked substrate.

After the substrate was sufficiently washed with an organic solvent and water, a conductor having a three-layered structure consisting of 0.1 $\mu$m thick Cr, 3 $\mu$m thick Cu and 0.1 $\mu$m thick Au was formed by sputtering, with the (thin film) method. The wiring circuit in this case was produced by forming the mask of the wiring pattern shown in Fig. 1 from a stainless steel, putting the mask on the substrate and then sequentially vaporizing the metals described above.

[Example 5 (Table 5)]

Embedding the waveguide portions was accomplished by changing the thermal expansion coefficients of the waveguide material, substrate material and fusing material as shown in Nos. 1 through 5 of Table 5. Next, the occurrence of cracks on each substrate, to which the waveguide portion was thus embedded, was examined by a microscope (400X).

As a result, it was confirmed that the substrate of the present invention could be produced without any problem if the differences of the thermal expansion coefficients between the three members, that is, the waveguide material, the substrate material and the fusing material, were within the range of $15 \times 10^{-7}/°C$.

The differences of the thermal expansion coefficients were within the range of $\alpha \Delta = 0 \sim 15$ for Examples Nos. 1 through 4. As a result of the examination of each substrate using a microscope, it was confirmed that no crack occurred on the substrate.

The light emitting element 9, the photo detector 8 and the optical transmission fiber (multi-mode fiber) 6 or the electric elements 7, 10 necessary for driving the elements 8, 9 were mounted to each of the electric and optical circuit substrates produced by Examples No. 1 through 4, as shown in Fig. 3. As a result, the present invention could provide the following effects.

(1)   Reduction of the size of the module,

(2)   Improvement of the optical coupling efficiency,

(3)   Mitigation of allowance for setting and mounting,

(4)   Reduction of the number of man-hours for the module assembly,

(5)   Reduction of the assembly time of the module,

(6)   Reduction of cost of production of the module.

Industrial Applicability:

An optical communication module in the field of optical communications can be cited as an example which exhibits the most remarkable effect by employing the present invention. However, the present invention is not limited to this field, in particular, but can be applied to all the technical fields which convert optical signals to electric signals or vice versa, or those fields which use photoelectric conversion technique including both of the conversion techniques described above.

WHAT IS CLAIMED IS:

1. An optical transmission module assemlby substrate characterized in that a waveguide portion is embedded into a part of a substrate, an electric wiring portion is formed on at least one of the surfaces of said substrate, and photoelectric conversion elements are connected to said electric wiring portion.

2. The optical transmission module assembly substrate as defined in claim 1 wherein a pair of said optical waveguide portions are embedded, a photo detector is mounted on said substrate in such a manner as to continue the optical axis of one of said optical waveguide portions, and a light emitting element is mounted on said substrate in such a manner as to continue the optical axis of the other of said optical waveguide portions.

3. The optical transmission module assembly substrate as defined in claim 1 wherein said optical waveguide portion is fixed to said substrate by a fusing material.

4. The optical transmission module assembly substrate as defined in claim 3 wherein the differences of linear thermal expansion coefficients between said optical waveguide portion, said substrate and said fusing material are up to $15 \times 10^{-7}/°C$.

FIG 16-01-85

1/2

0182920

FIG. 1

FIG. 2

FIG. 3

FIG. 4

# INTERNATIONAL SEARCH REPORT

**0182920**

International Application No. PCT/JP85/00296

## I. CLASSIFICATION OF SUBJECT MATTER (if several classification symbols apply, indicate all) ³

According to International Patent Classification (IPC) or to both National Classification and IPC

Int. Cl$^4$ G02B 6/42, H01L31/00-31/12, H01L33/00, H05K 1/18

## II. FIELDS SEARCHED

### Minimum Documentation Searched ⁴

| Classification System | Classification Symbols |
|---|---|
| IPC | G02B 6/42, H01L31/00-31/12, H01L33/00, H05K 1/18 |

### Documentation Searched other than Minimum Documentation to the Extent that such Documents are Included in the Fields Searched ⁵

| | | |
|---|---|---|
| Jitsuyo Shinan Koho | 1926 - 1985 | |
| Kokai Jitsuyo Shinan Koho | 1971 - 1985 | |

## III. DOCUMENTS CONSIDERED TO BE RELEVANT ¹⁴

| Category* | Citation of Document, ¹⁶ with indication, where appropriate, of the relevant passages ¹⁷ | Relevant to Claim No. ¹⁸ |
|---|---|---|
| A | JP, A, 58-206177 (Sumitomo Electric Industries, Ltd.) 1 December 1983 (01. 12. 83) (Family : none) | 1 - 4 |
| X | JP, U, 59-22407 (Omron Tateisi Electronics Co.) 10 February 1984 (10. 02. 84) (Family : none) | 1, 3 |
| X | JP, A, 53-50464 (International Business Machines Corp.) 8 May 1978 (08. 05. 78) & DE, A, 2745582 & FR, A, 2367714 & GB, A, 1529294 | 1, 2 |
| Y | JP, U. 59-22407 (Omron Tateisi Electronics Co.) 10 February 1984 (10. 02. 84) (Family : none) | 2, 4 |
| Y | JP, A, 59-77402 (Toshiba Corporation) 2 May 1984 (02. 05. 84) Page 2, upper right column, line 8 to 16 & EP, A, 112458 | 2 |
| Y | JP, A, 54-100745 (Oki Electric Industry Co., Ltd.) 8 August 1979 (08. 08. 79) Page 5, upper right column, line 19 to page 5, lower left column, line 4 (Family : none) | 4 |

* Special categories of cited documents: ¹⁶

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search ² | Date of Mailing of this International Search Report ² |
|---|---|
| July 18, 1985 (18. 07. 85) | July 29, 1985 (29. 07. 85) |
| International Searching Authority ¹ | Signature of Authorized Officer ²⁰ |
| Japanese Patent Office | |

Form PCT/ISA/210 (second sheet) (October 1981)